# EUROPEAN PATENT APPLICATION

(11) **EP 3 448 050 A1**
(43) Date of publication of application: **27.02.2019**
(21) Application number: 17187566.9
(22) Date of filing: 23.08.2017
(51) Int. Cl.: H04N 21/442, H04N 21/485, H04N 21/45, H03G 3/02, H04N 21/439

(54) **ELECTRONIC DEVICE WITH START-UP AUDIO VOLUME DERIVED FROM SELECTIONS STORED IN USER PROFILE**

(71) Applicant: Vestel Elektronik Sanayi ve Ticaret A.S., 45030 Manisa (TR)
(72) Inventor: ÖZBAY,, Mustafa Caner, 45030 Manisa (TR)
(74) Representative: Flint, Adam

(57) **Abstract**

An electronic device (1) has an audio playback function. The electronic device (1) includes a data storage (6) and a controller (7). The controller (7) records a user profile (20) of a user using the electronic device (1). The user profile (20) includes a volumes for audio playback by the electronic device (1) selected by a user at a number of time intervals (21). When the electronic device (1) is activated, the controller (7) obtains a start-up volume for the electronic device (1) from the user profile (20) and sets the start-up volume of the electronic device (1) in accordance with the obtained start-up volume from the user profile (20).

## Description

### Technical Field

The present disclosure relates to an electronic device, a method of operating an electronic device and a computer program.

### Background

Electronic devices, such as televisions, mobile phones, tablet computers etc., typically have an audio playback function and therefore include one or more speakers that can output the sound of media content, such as films/movies, television programmes etc. The volume of the audio playback function output by the speakers (i.e. the loudness of the sound) can be increased or decreased by a user depending on the user's preference. For example, if the electronic device is a television and the user is watching a sports match or an action movie, the user may increase the volume. If the electronic device is a television and the user is watching media content at night, the user may decrease the volume.

### Summary

According to a first aspect disclosed herein, there is provided an electronic device having an audio playback function, the electronic device comprising: a data storage; and a controller configured to: record a user profile of a user using the electronic device, the user profile including volumes for audio playback by the electronic device selected by a user at a number of time intervals; store the user profile in the data storage; and when the electronic device is activated: obtain a start-up volume for the electronic device from the user profile; and set the start-up volume of the electronic device in accordance with the obtained start-up volume from the user profile.

This allows the controller to automatically set the start-up volume (i.e. the initial volume of the sound output by the electronic device when it is activated) to a level that is an average of the user's preferred volume level. This means that the volume of the electronic device when it is activated by a user is not overly loud or too quiet. This provides an improved user experience, reduces the user's frustration and avoids disturbing sleeping neighbours and/or family members, particularly when the electronic device is activated at night.

In an example, the recorded volume for a time interval is an average volume selected by the user for the time interval based on historical data.

In an example, the user profile includes the volume for audio playback by the electronic device selected by a user for one of more characteristics of media content being output by the electronic device as it is used by a user, the recorded volume being the average volume selected by the user for a particular media content characteristic over a time interval.

In an example, the one or more characteristics of media content being output by the electronic device comprise the genre of the media content.

In an example, the controller is configured so that a user profile can be deleted by a user.

In an example, the controller is configured so that the recorded volumes in a user profile can be deleted by a user.

In an example, the controller is configured so that the recorded volumes in a user profile can be edited by a user.

According to a second aspect disclosed herein, there is provided a method of operating an electronic device, the method comprising: recording a user profile of a user using the electronic device, the user profile including volumes for audio playback by the electronic device selected by a user at a number of time intervals; storing the user profile in a data storage; and when the electronic device is activated: obtaining a start-up volume for the electronic device from the user profile; and setting the start-up volume of the electronic device in accordance with the obtained start-up volume from the user profile.

In an example, the recorded volume for a time interval is an average volume selected by the user for the time interval based on historical data.

In an example, the user profile includes the volume for audio playback by the electronic device selected by a user for one of more characteristics of media content being output by the electronic device as it is used by a user, the recorded volume being the average volume selected by the user for a particular media content characteristic over a time interval.

In an example, the one or more characteristics of media content being output by the electronic device comprise the genre of the media content.

In an example, the method comprises deleting a user profile in response to user input.

In an example, the method comprises deleting the recorded volumes of a user profile in response to user input.

In an example, the method comprises editing the recorded volumes in a user profile in response to user input.

According to a third aspect disclosed herein, there is provided a computer program comprising instructions such that when the computer program is executed on an electronic device, the electronic device is arranged to: record a user profile of a user using the electronic device, the user profile including volumes for audio playback by the electronic device selected by a user at a number of time intervals; store the user profile in a data storage of the electronic device; and when the electronic device is activated: obtain a start-up volume for the electronic device from the user profile; and set the start-up volume of the electronic device in accordance with the obtained start-up volume from the user profile.

### Brief Description of the Drawings

To assist understanding of the present disclosure and to show how embodiments may be put into effect, reference is made by way of example to the accompanying drawings in which:
Figure 1 shows schematically an elevation view of an example of an electronic device;
Figure 2 shows an example of a table stored in a data storage of the electronic device shown in Figure 1;
Figure 3 shows an example of a populated table stored in a data storage of the electronic device shown in Figure 1; and
Figure 4 shows an example of a method of operation of the electronic device shown in Figure 1.

### Detailed Description

Electronic devices, such as televisions, mobile phones, computers, etc., typically have an audio playback function and therefore include or are connected to one or more speakers that can output the sound of media content, such as films/movies, television programmes, etc. The volume of the audio playback function output by the speakers (i.e. the loudness of the sound) can be increased or decreased by a user depending on the user's preference. For example, if the electronic device is a television and the user is watching a sports match or an action movie, the user may increase the volume. If the electronic device is a television and the user is watching media content at night, the user may decrease the volume.

When a user activates an electronic device to play back media (by for example turning on or waking up a television, activating a media player on a computer, etc.), the volume (i.e. loudness) is typically initially set automatically to the volume that was last set by a user before the electronic device was last deactivated. This can be problematic in certain situations when the volume of the electronic device before it was deactivated is very different from the volume now desired by a user when the electronic device is activated. For example, if a user activates the electronic device at night time after having previously set the volume of the electronic device to be very loud because they were watching a sports match during the day, the loudness of the sound output by the electronic device may disturb or wake up the user's family and/or neighbours. At best, this contrast between the previously set volume and the user's desired volume is inconvenient.

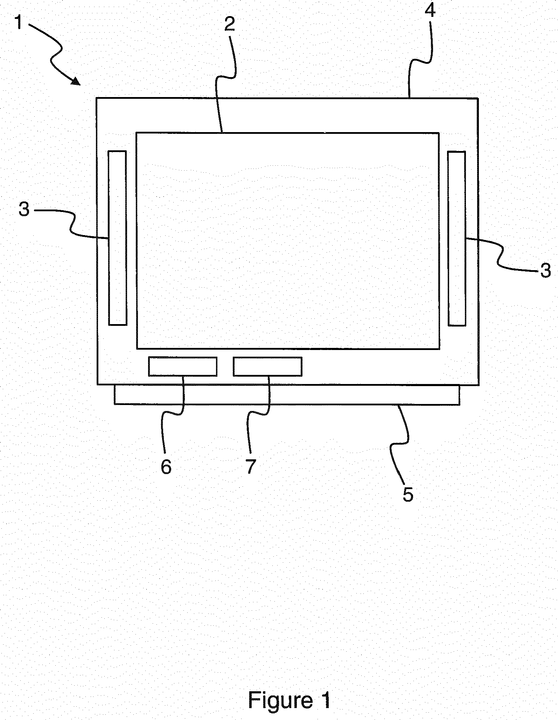

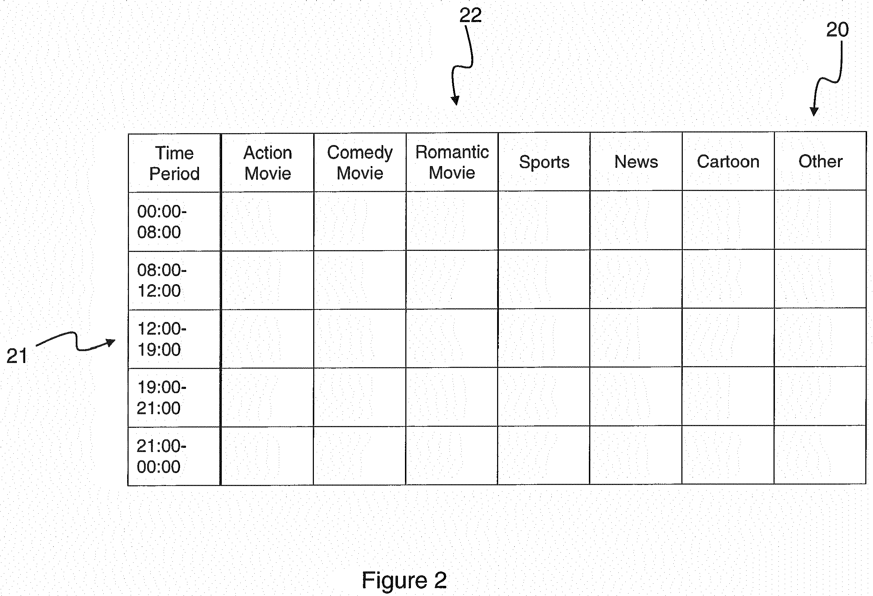

Referring now to Figures 1 and 2, there is shown schematically an example of an electronic device 1 including a display 2 and two loudspeakers 3. The display 2 and the speakers 3 are held within a housing 4. The housing 4 is supported off of the ground by a base 5. In this example, the electronic device 1 is a television. In another example, the electronic device 1 is another device that has an audio playback/output function. For example, the electronic device 1 may be a mobile phone (e.g. a smart phone or the like), a computer such as a personal computer, laptop or tablet, some other computer visual display unit, a radio, etc.

The speakers 3 output sound corresponding to media content being output by the electronic device 1. The volume (i.e. loudness) of the speakers 3 is adjustable. The speakers 3 may be for example dynamic speakers.

The base 5 provides for a connection (not shown) to a source of electricity, such as a mains electricity connection. The electronic device 1 also includes a power button (not shown) for activating and deactivating the electronic device 1.

The electronic device 1 also includes a data storage 6 and a controller 7.

The data storage 6 stores information on one or more user profiles, which will be explained below.

The controller 7, which may be a processor or the like, is provided within the housing 4 for controlling the operation of the electronic device 1. The controller 7 is connected to the speakers 3 and the data storage 6.

The controller 7 is configured to record a user profile 20 of a user using the electronic device 1 and store the user profile 20 on the data storage 6. Figure 2 shows an example of a table for storing user profile data relating to the user profile 20. In particular, the controller 7 records the average volume for audio playback by the electronic device 1 selected by a user over a number of different time intervals 21. In this example, there are five different non-equal time intervals 21. In another example, there may be more time intervals so as to improve the accuracy of the user profile. In another example, there may be fewer time intervals so as to reduce to space used in the data storage. In another example, the time intervals may be equal.

In this example, the average volume is the average volume selected by a user within a particular time period on a particular day. In another example, the average volume is the average volume selected by a user within a particular time period over a number of days.

In this example, the user profile 20 recorded by the controller 7 also includes one or more characteristics of media content 22 being output by the electronic device 1 as the electronic device 1 is used by the user. In this example, the characteristics are the genre (e.g. action, romantic comedy, sport, news, cartoon, etc.) and category (e.g. movie, television programme, etc.) of the media content.

In an example, the user profile 20 is continually updated by the controller 7 as the user uses the electronic device 1. In an example, the controller 7 is also configured so that the user can delete a user profile 20 from the data storage 6. In an example, the controller 7 is also configured so that a user can delete the data in a user profile 20 (i.e. reset the user profile). In an example, the controller 7 is also configured so that the user can edit the data in a user profile.

The controller 7 is configured to obtain a start-up volume for the electronic device 1 (i.e. the initial volume of the sound output by the electronic device 1 when it is activated) from the user profile 20 when the electronic device 1 is activated (by for example turning on or waking up the electronic device 1, activating a media player on the electronic device 1, etc.). The controller 7 is also configured to set the start-up volume of the electronic device 1 in accordance with the obtained start-up volume from the user profile 20.

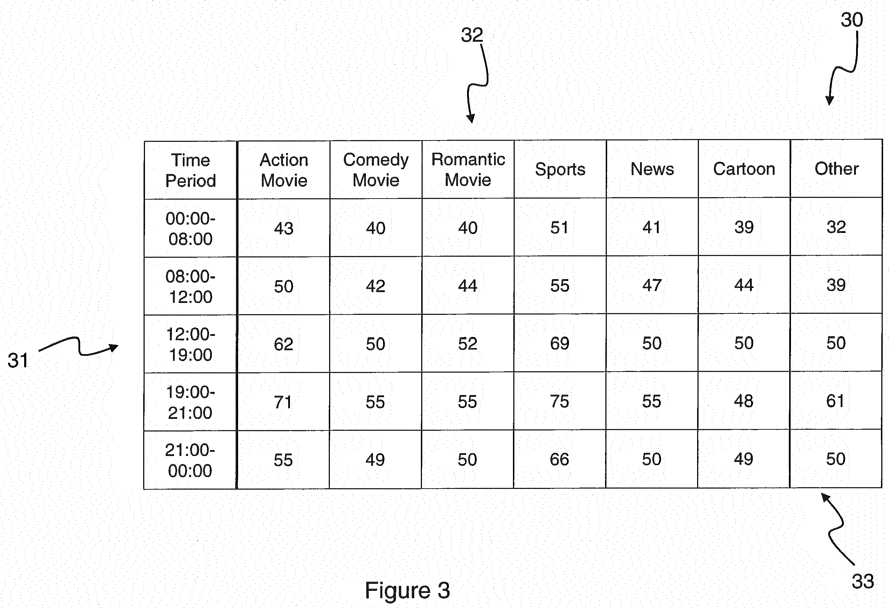

Figure 3 shows an example of a table including a user profile 30 that has been recorded by the controller 7. The user profile 30 includes the average volume levels 33 of the electronic device 1 selected by a user during the specified time intervals 31. In this example, the user profile 30 further breaks down the average volume levels 33 for different genres and categories 32 of the media content being output by the electronic device 1. The user can select a volume of between 1 and 100, with 0 being no sound output (i.e. mute) and 100 being the maximum loudness that can be output by the electronic device 1. The volume is selectable in intervals of 1.

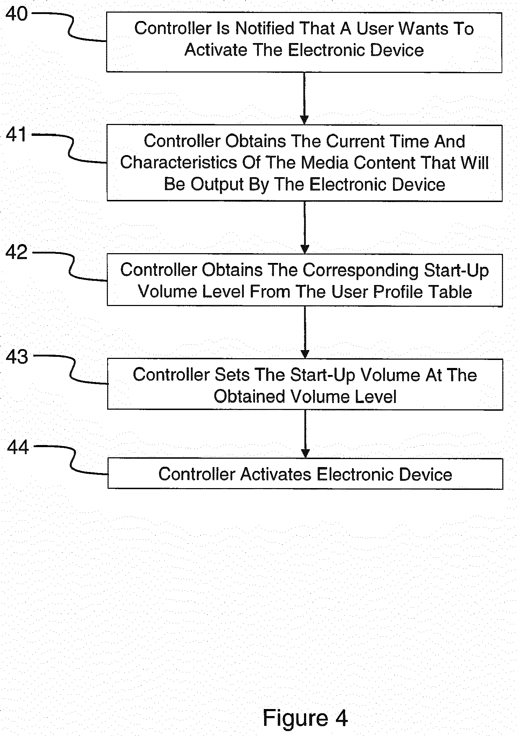

An example of a method of the controller setting a start-up volume of the audio playback function of the electronic device 1 is shown in Figure 4.

Initially, the electronic device 1 shown in Figure 1 is deactivated. However, the electronic device 1 has been previously used by a user and so the controller 7 has recorded a user profile 30 for the user, an example of which is shown in Figure 3.

At 40, the user, wanting to activate the electronic device 1, presses a power button located on the electronic device 1. The controller 7 is notified that the power button has been pressed and that the electronic device 1 is to be activated.

At 41, in response to the user pressing the power button, the controller 7 obtains the current time and characteristics of the media content that will be output by the electronic device 1 when it activates. In this example, the characteristics are the genre and category of the media content. Accordingly, in this example, the controller 7 obtains a time of 20:03, a category of "movie" and a genre of "action".

At 42, the controller 7 then obtains the start-up volume of the electronic device 1 from the user profile 30 that corresponds with, in this example, the current time and characteristics of the media content that will be output by the electronic device 1 when it activates. Accordingly, in this example, since the controller 7 obtains a time of 20:03 and the media content that will be output is an action movie, the controller obtains a start-up volume of 71.

At 43, the controller 7 then sets the start-up volume to be the volume obtained from the user profile 30. Therefore, in this example, the controller 7 sets the start-up volume of the electronic device to be 71.

At 44, after having set the start-up volume of the electronic device 1, the controller 7 activates the electronic device 1, which outputs sound having a volume of 71 relative to the electronic device's volume scale.

An advantage of this arrangement is that the controller can set the initial volume of the sound output by the electronic device when it is activated (i.e. the start-up volume) to a level that is an average of the user's preferred volume level. This means that the volume of the electronic device when it is activated by a user is not overly loud or too quiet, which provides an improved user experience, reduces the user's frustrations and avoids disturbing any sleeping neighbours and/or family members.

Although at least some aspects of the examples described herein with reference to the drawings comprise methods performed in the controller/processor 7, the invention also extends to computer programs, particularly computer programs on or in a carrier or computing device, adapted for putting the invention into practice. The program may be in the form of non-transitory source code, object code, a code intermediate source and object code such as in partially compiled form, or in any other non-transitory form suitable for use in the implementation of processes according to the invention. The carrier may be any entity or device capable of carrying the program. For example, the carrier may comprise a storage medium (e.g. the data storage 6), such as a solid-state drive (SSD) or other semiconductor-based RAM; a ROM, for example a CD ROM or a semiconductor ROM; a magnetic recording medium, for example a floppy disk or hard disk; optical memory devices in general; etc.

It will be understood that the controller/processor 7 referred to herein may in practice be provided by a single chip or integrated circuit or plural chips or integrated circuits, optionally provided as a chipset, an application-specific integrated circuit (ASIC), field-programmable gate array (FPGA), digital signal processor (DSP), graphics processing units (GPUs), etc. The chip or chips may comprise circuitry (as well as possibly firmware) for embodying at least one or more of a data processor or processors and a digital signal processor or processors, which are configurable so as to operate in accordance with the exemplary embodiments.

Reference is made herein to data storage for storing data. This may be provided by a single device or by plural devices. Suitable devices include for example a hard disk and non-volatile semiconductor memory.

The example described herein are to be understood as illustrative examples of embodiments of the invention. Further embodiments and examples are envisaged. Any feature described in relation to any one example or embodiment may be used alone or in combination with other features. In addition, any feature described in relation to any one example or embodiment may also be used in combination with one or more features of any other of the examples or embodiments, or any combination of any other of the examples or embodiments. Furthermore, equivalents and modifications not described herein may also be employed within the scope of the invention, which is defined in the claims.

## Claims

1. An electronic device having an audio playback function, the electronic device comprising:
a data storage; and
a controller configured to:
record a user profile of a user using the electronic device, the user profile including volumes for audio playback by the electronic device selected by a user at a number of time intervals;
store the user profile in the data storage; and
when the electronic device is activated: obtain a start-up volume for the electronic device from the user profile; and
set the start-up volume of the electronic device in accordance with the obtained start-up volume from the user profile.

2. An electronic device according to claim 1, wherein the recorded volume for a time interval is an average volume selected by the user for the time interval based on historical data.

3. An electronic device according to claim 1 or claim 2, wherein the user profile includes the volume for audio playback by the electronic device selected by a user for one of more characteristics of media content being output by the electronic device as it is used by a user, the recorded volume being the average volume selected by the user for a particular media content characteristic over a time interval.

4. An electronic device according to claim 3, wherein the one or more characteristics of media content being output by the electronic device comprise the genre of the media content.

5. An electronic device according to any preceding claim, wherein the controller is configured so that a user profile can be deleted by a user.

6. An electronic device according to any preceding claim, wherein the controller is configured so that the recorded volumes in a user profile can be deleted by a user.

7. An electronic device according to any preceding claim, wherein the controller is configured so that the recorded volumes in a user profile can be edited by a user.

8. A method of operating an electronic device, the method comprising:
recording a user profile of a user using the electronic device, the user profile including volumes for audio playback by the electronic device selected by a user at a number of time intervals;
storing the user profile in a data storage of the electronic device; and
when the electronic device is activated: obtaining a start-up volume for the electronic device from the user profile; and
setting the start-up volume of the electronic device in accordance with the obtained start-up volume from the user profile.
wherein the recorded volume for a time interval is an average volume selected by the user for the time interval based on historical data

9. A method according to claim 8, wherein the recorded volume for a time interval is an average volume selected by the user for the time interval based on historical data.

10. A method according to claim 8 or claim 9, wherein the user profile includes the volume for audio playback by the electronic device selected by a user for one of more characteristics of media content being output by the electronic device as it is used by a user, the recorded volume being the average volume selected by the user for a particular media content characteristic over a time interval.

11. A method according to claim 10, wherein the one or more characteristics of media content being output by the electronic device comprise the genre of the media content.

12. A method according to any one of claims 8 to 11, comprising deleting a user profile in response to a user input.

13. A method according to any one of claims 8 to 12, comprising deleting the recorded volumes of a user profile in response to a user input.

14. A method according to any one of claims 8 to 13, comprising editing the recorded volumes in a user profile in response to a user input.

15. A computer program comprising instructions such that when the computer program is executed on an electronic device, the electronic device is arranged to:
record a user profile of a user using the electronic device, the user profile including a volume for audio playback by the electronic device selected by a user at a number of time intervals;
store the user profile in a data storage of the electronic device; and
when the electronic device is activated: obtain a start-up volume for the electronic device from the user profile; and
set the start-up volume of the electronic device in accordance with the obtained start-up volume from the user profile.
